# EUROPÄISCHE PATENTSCHRIFT

(11) **EP 0 588 793 B1**
(45) Veröffentlichungstag und Bekanntmachung des Hinweises auf die Patenterteilung: **12.04.1995**
(21) Anmeldenummer: 92902384.4
(22) Anmeldetag: 09.01.1992
(51) Int. Cl.: B60R 16/02, H05K 7/20

(54) **GEHÄUSE FÜR KFZ-ELEKTRONIK**
HOUSING FOR MOTOR VEHICLE ELECTRONICS
BOITIER POUR COMPOSANTS ELECTRONIQUES D'AUTOMOBILE

(30) Priorität: 26.01.1991 DE 4102265
(43) Veröffentlichungstag der Anmeldung: 30.03.1994
(73) Patentinhaber: TEMIC TELEFUNKEN microelectronic GmbH, 74072 Heilbronn (DE); ITT Automotive Europe GmbH, 60488 Frankfurt (DE)
(72) Erfinder: SCHIRMER, Klaus, D-8070 Ingolstadt (DE); BURGDORF, Jochen, D-6050 Offenbach-Rumpenheim (DE); LORECK, Heinz, D-6270 Idstein 2 (DE)
(74) Vertreter: Maute, Hans-Jürgen, Dipl.-Ing.
(86) Internationale Anmeldenummer: EP9200027
(87) Internationale Veröffentlichungsnummer: WO9212875

(56) Entgegenhaltungen:
- DE-A- 2 626 328
- DE-A- 3 045 329
- DE-A- 3 837 974

## Beschreibung

Die Erfindung betrifft ein Gehäuse für den Einbau in Kraftfahrzeuge zur Aufnahme von auf einem Trägerkörper angeordneten Elektronikbauteilen gemäß dem Oberbegriff der Patentansprüche 1 und 2.

Ein solches Gehäuse ist aus der DE-A-3 837 974 bekannt. Dieses Gehäuse dient als Zündsteuergerät und enthält als Elektronikbauteile in Form einer Hybridschaltung eine Zündschaltung, einen Steuerteil, einen Leistungsteil und eine RC-Kombination.

Diese Bauteile befinden sich auf einem keramischen Trägerkörper, der elektrisch isolierend auf einem Kühlkörper angeordnet ist. Dieser Kühlkörper bildet zusammen mit einem einen Kunststoffrahmen aufweisenden Gehäuserahmen, einer Steckeranschlußbuchse und einem Deckel ein geschlossenes Gehäuse. Ferner weist dieses Gehäuse eine Metallplatine auf, die in dem Gehäusekörper, zwischen den Bauteilen und dem Deckel, integriert ist, und zur Kontaktierung der Bauteile dient.

Solche Gehäuse dienen dazu, die sie aufnehmenden Elektronikbauteile vor den im Betrieb auftretenden Belastungen und Störungen ausreichend zu schützen. Hierzu können solche Gehäuse auch teilweise oder vollständig als Metallgehäuse ausgeführt sein, um elektromagnetische Störungen (EMV-Störungen) zu unterdrücken. Gleichzeitig dient ein solches Metallgehäuse zur Wärmeabfuhr der elektrischen Verlustleistung, wobei dies bei einer Umgebungstemperatur von - 40 °C bis 120 °C beispielsweise durch zusätzliche Verwendung von Kühlrippen sichergestellt werden kann.

Diese Anforderung bezüglich der Temperaturbeständigkeit zusammen mit der Forderung, daß das Gehäuse dicht ist, macht das gesamte Gehäuse motorraumtauglich. Um alle diese Forderungen zu erfüllen, werden für solche Gehäuse oft aufwendige Aufbauten, wie dies bei dem oben beschriebenen bekannten Gehäuse der Fall ist, vorgesehen, was auch hohe Herstellkosten zur Folge hat.

Diese Aufgabe der Erfindung besteht daher darin, ein Gehäuse der eingangs genannten Art zu schaffen, das einen einfachen Aufbau aufweist und somit kostengünstig herstellbar ist.

Diese Aufgabe wird gemäß den kennzeichnenden Merkmalen der Patentansprüche 1 und 2 gelöst.

Die erfindungsgemäß vorgesehene Metallplatte dient einerseits als Träger für die Multilayer-Leiterplatte oder Multilayer-Folie und die Leistungsbauelemente - und somit als Wärmesenke - und als Teil des Gehäuses andererseits. Hierdurch ist es möglich sowohl die Multilayer-Leiterplatte oder die Multilayer-Folie mit den SMD-Bauteilen und den Leistungsbauelementen als auch - bei der erstgenannten Lösung - die Metallplatte mit den Leistungsbauelementen automatisch zu bestücken. Besonders vorteilhaft ist es, den Stecker mechanisch auf der Metallplatte zu montieren, wobei gleichzeitig die Anschlußpins dieses Steckers auf die Multilayer-Leiterplatte bzw. die Multilayer-Folie geführt sind. Eine weitere, den Stecker mit der Leiterplatte verbindenden Verdrahtung entfällt daher. Durch die Verwendung einer Multilayer-Leiterplatte ist ein Bedeckungsgrad von ca. 85 % erreichbar. Dieses erfindungsgemäße Gehäuse weist daher einen einfachen und kompakten Aufbau auf, wobei dessen Herstellung vollautomatisch erfolgen kann, mit der Folge, daß auch die Herstellungskosten gering gehalten werden können.

Bei einer bevorzugten Ausbildungsform der Erfindung wird der Stecker an einer vorteilhaften Stelle angeordnet, nämlich dort, wo er sich in unmittelbarer Nachbarschaft zu den Leistungsbauelementen befindet. Somit können beispielsweise die Leistungsbauelemente räumlich durch den Stecker von den die Steuerelektronik aufbauenden SMD-Bauteilen getrennt werden. Durch diese Lage des Steckers ist es möglich, die Anschlußleitungen für die Leistungsbauelemente möglichst kurz auszubilden, wodurch Leiterplattenfläche eingespart werden kann und zusätzlich die Störempfindlichkeit vermindert wird, da beispielsweise andere Signalpfade zu den Leistungsbauelementen nicht mehr direkt benachbart sind.

Gemäß einer besonders vorteilhaften Weiterbildung der Erfindung ist die Metallplatte rechteckförmig mit einer Länge und einer Breite ausgebildet und die Form der Multilayer-Leiterplatte so gewählt, daß deren Länge nahezu derjenigen der Metallplatte entspricht und deren Breite um einen solchen Betrag geringer ist als diejenige der Metallplatte, daß die hierdurch entstehende rechteckförmige Fläche zur Aufnahme der Leistungsbauelemente ausreichend ist. Hierdurch ist es möglich, den Stecker unmittelbar benachbart zu diesen Leistungsbauelementen anzuordnen, wodurch die Länge der Anschlußleitungen dieser Leistungsbauelemente minimiert werden.

Es ist bei einer anderen bevorzugten Ausbildungsform der Erfindung vorgesehen, die Metallplatte und die Multilayer-Folie rechteckförmig mit jeweils identischer Länge und Breite auszubilden. Hierbei können die Leistungsbauelemente bei Verwendung einer dünnen, einseitig kupferkaschierten Multilayer-Folie auf dieselbe aufgelötet werden.

Bei einer weiteren Fortbildung des erfindungsgemäßen Gehäuses ist der Stecker über die gesamte Länge der Metallplatte geführt und weist an den schmalen Stirnseiten über die Metallplatte hinausragende Flanschstücke auf, wodurch eine einfache Montage des Gehäuses im Kraftfahrzeug möglich ist und die Steckkräfte direkt auf die Befestigungspunkte abgeleitet werden.

Bei einer weiteren vorteilhaften Weiterbildung der Erfindung kann die Kupplungsrichtung des Steckers senkrecht auf der Metallplatte stehen. Eine besonders vorteilhafte Ausbildung des Steckers ist dann erzielbar, wenn dessen Kupplungsrichtung parallel zur flächigen Ausdehnung der Metallplatte verläuft. Damit ist ein Gebilde mit besonders kompaktem Aufbau gegeben.

Um das erfindungsgemäße Gehäuse motorraumtauglich zu machen, ist der Stecker mechanisch dicht mittels Befestigungsmitteln auf der Metallplatte montiert.

Eine den einfachen Aufbau des erfindungsgemäßen Gehäuses unterstützende Maßnahme besteht darin, daß die Leistungsbauelemente elektrisch isolierend auf die Metallplatte geklebt sind oder mit gutem Wärmekontakt zur Metallplatte auf die Multilayer-Folie gelötet sind.

Schließlich kann die Metallplatte, die die Multilayer-Leiterplatte bzw. Multilayer-Folie, die Leistungsbauelemente sowie den Stecker trägt, dadurch zu einem vollständigen Gehäuse komplettiert werden, indem ein haubenförmig ausgebildeter Deckel die die Leiterplatte bzw. Folie tragende Seite der Metallfläche formschlüssig abdeckt. Bei einer anderen Ausführungsform der Erfindung kann anstatt des Deckels ein Verguß vorgesehen werden, der als Partial-Teil- oder Vollverguß ausgebildet sein kann.

Im folgenden soll die Erfindung anhand von Ausführungsbeispielen im Zusammenhang mit den Zeichnungen näher erläutert werden.

Es zeigen:
- Figur 1: eine Draufsicht auf die die Bauelemente tragenden Metallplatte eines ersten Ausführungsbeispieles des erfindungsgemäßen Gehäuses,
- Figur 2: eine Seitenansicht des Ausführungsbeispieles nach Figur 1 auf die Längsseite des Steckers,
- Figur 3: eine Seitenansicht des Ausführungsbeispieles nach Figur 1 auf die Schmalseite des Steckers,
- Figur 4: eine Seitenansicht eines zweiten Ausführungsbeispieles der Erfindung mit einem abgewinkelten Kupplungsteil des Steckers und
- Figur 5: eine Draufsicht auf ein zweites Ausführungsbeispiel der Erfindung.

In den Zeichnungen sind einander entsprechende Teile mit den gleichen Bezugszeichen versehen.

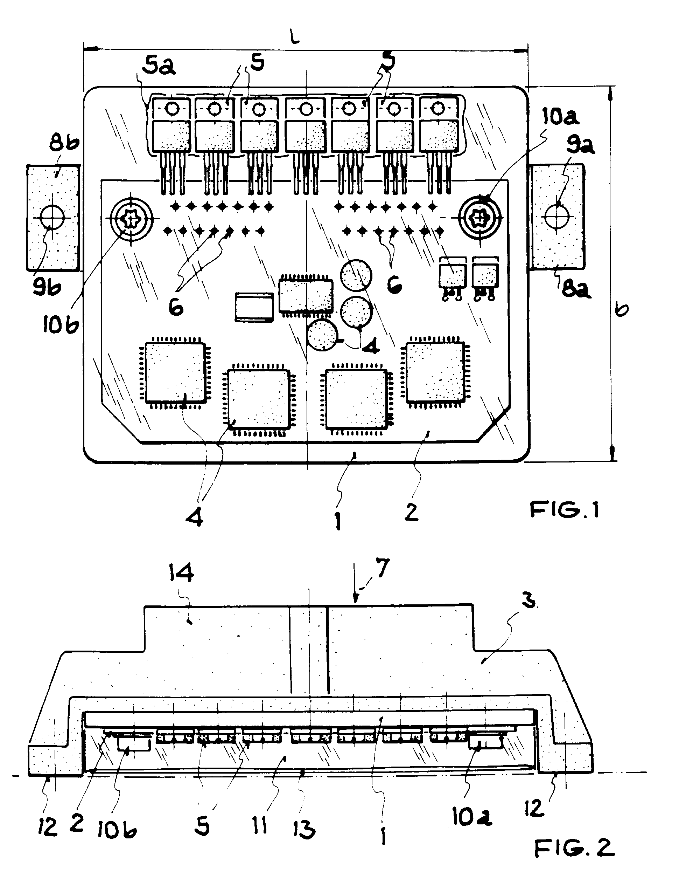

In Figur 1 und Figur 2 sind mit den Bezugszeichen 1, 2 und 3 eine massive Metallplatte, eine Multilayer-Leiterplatte sowie ein Stecker bezeichnet. Anstatt der Multilayer-Leiterplatte kann auch eine Multilayer-Folie eingesetzt werden. Die Metallplatte 1 ist beispielsweise aus Aluminium rechteckförmig ausgebildet, mit einer Länge l von 120 mm und einer Breite b von 100 mm. Eine Leiterplatte 2 mit bis auf einen Rand von ca. 2 mm nahezu gleicher Länge l und einer Breite, die kleiner ist als die Breite der Metallplatte 1 ist formschlüssig auf diese Leiterplatte 1 so elektrisch isolierend geklebt, daß eine Längskante dieser Multilayer-Leiterplatte 2 bündig bis auf einen Rand von ca. 2 mm mit der Längskante der Metallplatte 1 abschließt. Dadurch, daß diese Multilayer-Leiterplatte 2 schmaler ist als die Metallplatte 1, kann die auf der gegenüberliegenden Seite der Metallplatte 1 entstehende, von der Multilayer-Leiterplatte 2 nicht bedeckten rechteckförmigen Fläche Leistungsbauelemente, beispielsweise Leistungstransistoren 5 elektrisch isolierend mit einem Kleber 5a aufgeklebt werden. Die Multilayer-Leiterplatte 2 ist in SMD-Technologie gefertigt, trägt also SMD-Bauteile 4.

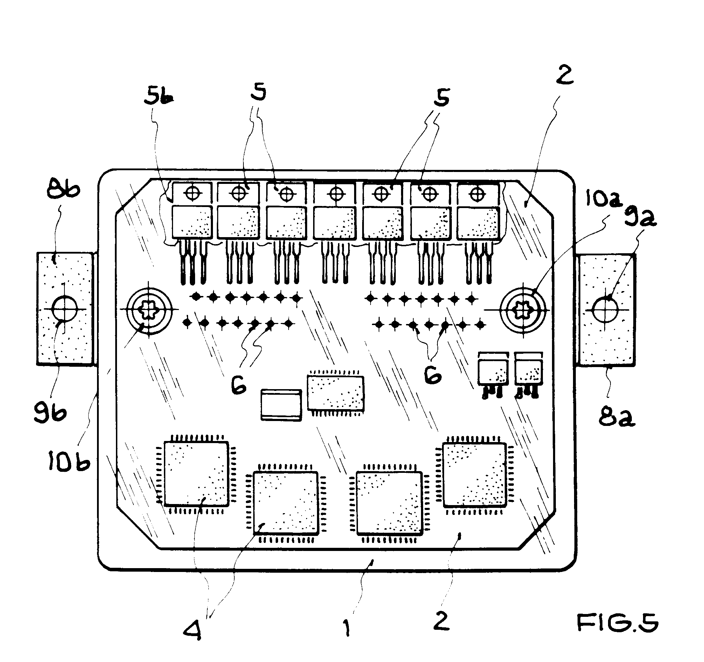

Bei dem Gehäuse nach Figur 5 wird anstatt der Multilayer-Leiterplatte eine Multilayer-Folie, beispielsweise aus Polyimid oder aus gleichwertigen hochtemperaturfesten flexiblen Substraten (Vlies, Glas, Seide etc.) verwendet. Dabei entspricht jedoch die Größe dieser Multilayer-Folie der Größe der Metallplatte 1. Auch bei diesem Ausführungsbeispiel sind die Leistungsbauelemente 5 in einer Reihe entlang einer Längsseite, wie bei dem Ausführungsbeispiel nach Figur 1 angeordnet. Um einen guten Wärmekontakt zu der Metallplatte 1 zu sichern, wird eine dünne Multilayer-Folie 2 verwendet, die einseitig kupferkaschiert ist. Auf diese kupferkaschierte Fläche werden die Leistungsbauelemente 5 mittels Lot 5b aufgelötet. Ansonsten entspricht der Aufbau demjenigen nach Figur 1.

Aufgrund dieses Aufbaues gemäß den Figuren 1 und 5 dient die Metallplatte 1 nicht nur als Träger für die Multilayer-Leiterplatte 2 bzw. Multilayer-Folie 2 und die Leistungstransistoren 5, sondern wirkt für diese Bauelemente auch als Wärmesenke.

Der beispielsweise 28polige Stecker 3 ist bei den Ausführungsbeispielen nach den Figuren 1 und 2 in Längsrichtung der Metallplatte 1 und direkt benachbart zu den Leistungstransistoren 5 über die Metallplatte 1 geführt und mit ihr über Schraubverbindungen 10a und 10b verbunden. Dabei ist nach Figur 1 dieser Stecker 3 im Randbereich der Multilayer-Leiterplatte 2, benachbart zu den Leistungstransistoren 5 angeordnet, damit dessen Anschlußpins 6 auf diese Multilayer-Leiterplatte 2 geführt werden können. Auch nach Figur 5 sind die Anschlußpins 6 auf die Multilayer-Folie 2 geführt, wo sie verlötet werden. Alle SMD-Bauteile 4 können nun in einem einzigen Lötprozeßschritt gelötet werden. Um die Anschlußpins 6 des Steckers 3 auf die Folie 2 führen zu können, ist auf der Metallplatte 1 nach Figur 1 als auch nach Figur 5 ein entsprechender Durchbruch vorgesehen.

Der Stecker 3 weist über den Rand der Metallplatte 1 hinausragende Flanschstücke 8a und 8b auf, die jeweils eine Bohrung 9a und 9b aufweisen. Mittels dieser Bohrungen 9a und 9b kann das fertiggestellte Gehäuse im Kraftfahrzeug an die dafür vorgesehene Stelle montiert werden. Hierbei müssen gemäß Figur 2 die beiden Flanschstücke 8a und 8b so weit über die die Bauteile 4 und 5 tragenden Fläche der Metallplatte 1 ragen, daß deren Montagefläche 12 bündig mit der Oberfläche 13 des die Bauelemente 4 und 5 abdeckenden Teils 11 abschließt oder zumindest diese Oberfläche 13 überragt.

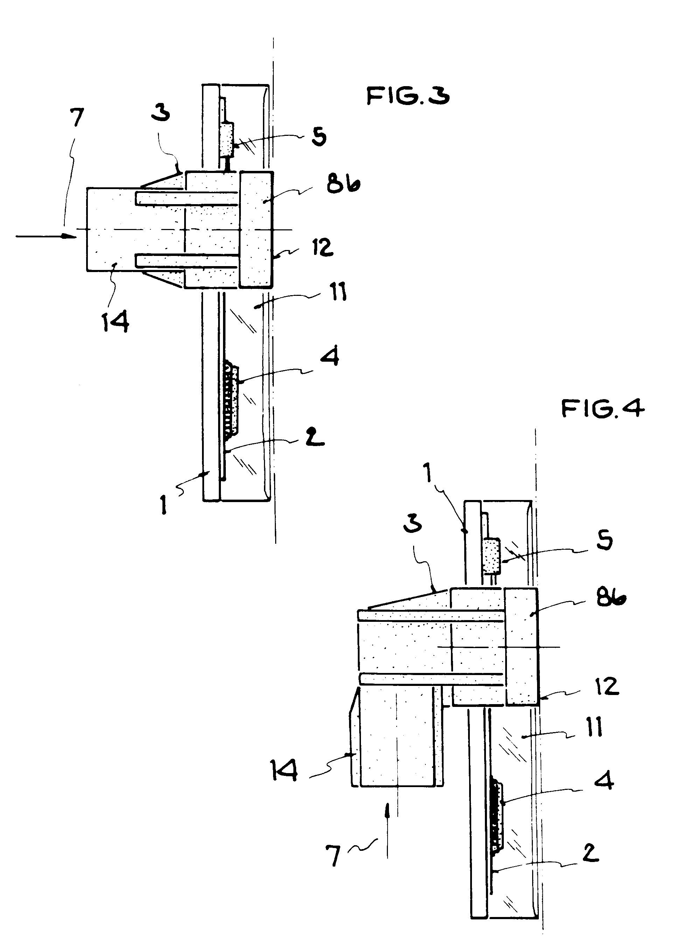

Schließlich übernimmt die Metallplatte 1 auch die Funktion eines Teils des Gehäuses. Der restliche Teil des Gehäuses wird dadurch realisiert, daß die Multilayer-Leiterplatte 2 bzw. die Multilayer-Folie 2 als auch die Leistungstransistoren 5 mittels eines Vollvergusses derart vergossen werden, daß gemäß der Figur 2 lediglich die die Multilayer-Leiterplatte 2 bzw. die Multilayer-Folie 2 tragende Seite der Metallplatte 1 abgedeckt wird, wobei dieser Vollverguß zusammen mit der Metallplatte 1 eine flache, quaderförmige Form gemäß der Figur 2 bildet. Hierbei weist beispielsweise diese Form eine Dicke von ca. 12 mm auf. Auf der freien Seite der Metallplatte 1 ist lediglich der Kupplungsteil 14 des Steckers 3 zu erkennen, deren Kupplungsrichtung - siehe Pfeil 7 - gemäß Figuren 2 und 3 senkrecht auf der Metallplatte 1 steht. Die gesamte Dicke der Anordnung nach Figur 1 beträgt ausschließlich des durch das Kupplungsteil 14 des Steckers 3 bedingten Überstandes lediglich 45 mm. Anstatt eines Vollvergusses kann auch ein Partial- oder Teilverguß durchgeführt werden, wobei dann noch ein Kunststoffdeckel als Abschluß aufgeklipst wird. Dies ist noch eine kostengünstigere Lösung im Vergleich zu einem Vollverguß.

Das Ausführungsbeispiel nach Figur 4 unterscheidet sich von demjenigen nach Figuren 1 oder 2 lediglich in der Ausführung des Steckers 3. In dieser Figur 4 ist lediglich eine der Figur 3 entsprechende Seitenansicht auf die Schmalseite des Steckers 3 gezeigt, um die unterschiedlichen Ausführungsarten des Kupplungsteils 14 darzustellen. Hiernach ist der Kupplungsteil 14 des Steckers 3 gemäß Figur 4 rechtwinklig zur Metallplatte 1 abgeknickt, so daß die Kupplungsrichtung - siehe Pfeil 7 - parallel zur flächigen Ausdehnung der Metallplatte 1 verläuft. Zusammen mit einem in der Figur 4 nicht dargestellten Anschlußkabel werden besonders kompakte Einbauverhältnisse erzielt.

Ein wesentlicher Vorteil des in den Ausführungsbeispielen dargestellten erfindungsgemäßen Gehäuses ist die vollautomatische Herstellung desselben. Hierdurch ist eine besonders kostengünstige Herstellung dieses erfindungsgemäßen Gehäuses durchführbar.

## Patentansprüche

1. Gehäuse für den Einbau in Kraftfahrzeuge zur Aufnahme von auf einem Trägerkörper angeordneten Elektronikbauteilen, wobei der Trägerkörper sich auf einem Kühlkörper befindet und ferner ein Stecker (3) die elektrische Verbindung zu den Elektronikbauteilen herstellt, dadurch gekennzeichnet,
- daß eine Multilayer-Leiterplatte (2) oder eine Multilayer-Folie (2) als Trägerkörper vorgesehen ist, die auf einer Seite SMD-Elektronikbauteile (4) trägt,
- daß als Kühlkörper eine Metallplatte (1) vorgesehen ist, wobei diese Metallplatte (1) in ihrer flächenhaften Ausdehnung großer ist als die Multilayer-Leiterplatte (2) bzw. Multilayer-Folie (2),
- daß die Multilayer-Leiterplatte (2) bzw. die Multilayer-Folie (2) isolierend und flächenschlüssig auf der Metallplatte (1) angeordnet ist,
- daß auf der von der Multilayer-Leiterplatte (2) bzw. Multilayer-Folie (2) nicht bedeckten Fläche der Metallplatte (1) Leistungsbauelemente (5) angeordnet sind, wobei diese Metallplatte (1) als Wärmesenke für diese Leistungsbauelemente (5) dient,
- daß auf der Metallplatte (1) im Bereich der Multilayer-Leiterplatte (2) bzw. Multilayer-Folie (2) ein Stecker (3) derart montiert ist, daß dessen Anschlußpins (6) in die Multilayer-Leiterplatte (2) bzw. Multilayer-Folie (2) geführt sind und die Kupplungsseite (7) dieses Steckers (3) auf der flächigen Seite der Metallplatte (1) liegt, die derjenigen gegenüberliegt, die die Multilayer-Leiterplatte (2) bzw. Multilayer-Folie (2) trägt,
- und daß mechanische Mittel (11) vorgesehen sind, die zusammen mit der Metallplatte (1) ein flaches Gehäuse bilden, wobei lediglich die Seite der Metallplatte (1) durch diese Mittel (11) formschlüssig abgedeckt wird, die die Multilayer-Leiterplatte (2) bzw. Multilayer-Folie (2) trägt.

2. Gehäuse für den Einbau in Kraftfahrzeuge zur Aufnahme von auf einem Trägerkörper angeordneten Elektronikbauteilen, wobei der Trägerkörper sich auf einem Kühlkörper befindet und ferner ein Stecker (3) die elektrische Verbindung zu den Elektronikbauteilen herstellt, dadurch gekennzeichnet,
- daß eine Multilayer-Folie (2) als Trägerkörper vorgesehen ist, die auf einer Seite SMD-Elektronikbauteile (4) trägt,
- daß als Kühlkörper eine Metallplatte (1) vorgesehen ist, wobei diese Metallplatte (1) in ihrer flächenhaften Ausdehnung derjenigen der Multilayer-Folie (2) entspricht,
- daß die Multilayer-Folie (2) isolierend und flächenschlüssig auf der Metallplatte (1) angeordnet ist,
- daß auf der Metallplatte (1) ein Stecker (3) derart montiert ist, daß dessen Anschlußpins (6) in die Multilayer-Folie (2) geführt sind und der diese Anschlußpins tragende Bereich der Multilayer-Folie (2) deren Fläche in einem ersten Bereich und einen zweiten Bereich teilt, wobei die Kupplungsseite (7) dieses Steckers (3) auf der flächigen Seite der Metallplatte (1) liegt, die derjenigen gegenüberliegt, die die Multilayer-Folie (2) trägt,
- daß im ersten Bereich der Multilayer-Folie (2) Leistungsbauelemente angeordnet sind,
- und daß mechanische Mittel (11) vorgesehen sind, die zusammen mit der Metallplatte (1) ein flaches Gehäuse bilden, wobei lediglich die Seite der Metallplatte (1) durch diese Mittel (11) formschlüssig abgedeckt wird, die die Multilayer-Folie (2) trägt.

3. Gehäuse nach Anspruch 1, dadurch gekennzeichnet, daß der Stecker (3) in unmittelbarer Nachbarschaft zu den Leistungsbauelementen (5) angeordnet ist.

4. Gehäuse nach Anspruch 1 oder 3, dadurch gekennzeichnet, daß die Leistungsbauelemente (5) mit gutem Wärmekontakt elektrisch isolierend auf die Metallplatte (1) geklebt sind.

5. Gehäuse nach Anspruch 2, dadurch gekennzeichnet, daß in unmittelbarer Nachbarschaft des Steckers (3) die Leistungsbauelemente angeordnet sind.

6. Gehäuse nach Anspruch 2 oder 5, dadurch gekennzeichnet, daß die Leistungsbauelemente (5) mit gutem Wärmekontakt zur Metallplatte (1) auf die Multilayer-Folie (2) gelötet sind.

7. Gehäuse nach Anspruch 1, 3 oder 4, dadurch gekennzeichnet, daß die Metallplatte (1) rechteckförmig mit einer Länge (l) und einer Breite (b) ausgebildet ist und die Form der Multilayer-Leiterplatte (2) bzw. Multilayer-Folie (2) so gewählt ist, daß deren Länge nahezu derjenigen der Metallplatte (1) entspricht und deren Breite um einen solchen Betrag geringer ist als diejenige der Metallplatte (1), daß die hierdurch entstehende rechteckförmige Fläche auf der Metallplatte (1) zur Aufnahme der Leistungsbauelemente (5) ausreichend ist.

8. Gehäuse nach Anspruch 2, 5 oder 6, dadurch gekennzeichnet, daß die Metallplatte (1) und die Multilayer-Folie (2) rechteckförmig mit einer Länge (l) und einer Breite (b) ausgebildet sind.

9. Gehäuse nach Anspruch 7 oder 8, dadurch gekennzeichnet, daß der Stecker (3) über die gesamte Länge der Metallplatte (1) geführt ist und daß der Stecker (3) zur Montage des Gehäuses beidseitig an seinen schmalen Stirnseiten mit Bohrungen (9a, 9b) versehene, über die Metallplatte (1) hinausragende Flanschstücke (8a, 8b) aufweist.

10. Gehäuse nach einem der vorangehenden Ansprüche, dadurch gekennzeichnet, daß die Metallplatte (1) einen Durchbruch für die Anschlußpins (6) aufweist.

11. Gehäuse nach einem der vorangehenden Ansprüche, dadurch gekennzeichnet, daß die Kupplungsrichtung (7) des Steckers (3) senkrecht auf der Metallplatte (1) steht.

12. Gehäuse nach einem der Ansprüche 1 bis 10, dadurch gekennzeichnet, daß die Kupplungsrichtung (7) des Steckers (3) parallel zur flächigen Ausdehnung der Metallplatte (1) verläuft.

13. Gehäuse nach einem der vorangehenden Ansprüche, dadurch gekennzeichnet, daß der Stecker (3) mechanisch dicht mittels Befestigungsmitteln (10a, 10b) auf der Metallplatte (1) montiert ist.

14. Gehäuse nach einem der vorangehenden Ansprüche, dadurch gekennzeichnet, daß als mechanisches Mittel zur Abdeckung der Elektronikbauteile ein haubenförmig ausgebildeter preisgünstiger Deckel vorgesehen ist.

15. Gehäuse nach einem der Ansprüche 1 bis 13, dadurch gekennzeichnet, daß zur Abdeckung der Elektronikbauteile sowie zum Schutz vor Feuchtigkeit und Korrosion ein Verguß der Elektronikbauteile vorgesehen ist.

16. Gehäuse nach Anspruch 15, dadurch gekennzeichnet, daß als Verguß ein Partial-Teil- oder Vollverguß vorgesehen ist.

## Claims

1. Housing for mounting in motor vehicles for the reception of electronic components disposed on a support member, wherein the support member is located on a heat sink and wherein furthermore a plug (3) produces the electrical connection to the electronic components, characterised in,
- that a multi-layer printed circuit board (2) or a multi-layer foil (2) is provided as the support member which carries SMD electronic components (4) on one side,
- that a metal plate (1) is provided as the heat sink, wherein this metal plate (1) is greater as regards its superficial area than the multi-layer printed circuit board (2) or the multi-layer foil (2),
- that the multi-layer printed circuit board (2) or the multi-layer foil (2) is arranged on the metal plate (1) in an insulating manner and with their surfaces in positive contact,
- that power components (5) are arranged on the surface of the metal plate (1) which is not covered by the multi-layer printed circuit board (2) or the multi-layer foil (2) whereby this metal plate (1) serves as a heat sink for these power components (5),
- that a plug (3) is mounted on the metal plate (1) in the vicinity of the multi-layer printed circuit board (2) or the multi-layer foil (2) in such a way that its contact pins (6) are guided into the multi-layer printed circuit board (2) or the multi-layer foil (2) and the coupling side (7) of this plug (3) is located on the flat side of the metal plate (1) which is opposite to that which carries the multi-layer printed circuit board (2) or the multi-layer foil (2),
- and that mechanical means (11) are provided which form a shallow housing in combination with the metal plate (1) whereby merely the side of the metal plate (1), which carries the multi-layer printed circuit board (2) or the multi-layer foil (2), is positively covered by these means (11).

2. Housing for mounting in motor vehicles for the reception of electronic components disposed on a support member, wherein the support member is located on a heat sink and wherein furthermore a plug (3) produces an electrical connection to the electronic components, characterised in,
- that a multi-layer foil (2) is provided as the support member which carries SMD electronic components (4) on one side,
- that a metal plate (1) is provided as the heat sink, wherein this metal plate (1) corresponds to that of the multi-layer foil (2) as regards its superficial area,
- that the multi-layer foil (2) is arranged on the metal plate (1) in an insulating manner and with their surfaces in positive contact,
- that a plug (3) is mounted on the metal plate (1) in such a way that its contact pins (6) are guided into the multi-layer foil (2) and the region of the multi-layer foil (2) which supports these contact pins divides its surface into a first region and a second region, wherein the coupling side (7) of this plug (3) is located on the flat side of the metal plate (1) which is opposite to that which carries the multi-layer foil (2),
- that power components are arranged in the first region of the multi-layer foil (2),
- and that mechanical means (11) are provided which form a shallow housing in combination with the metal plate (1) whereby merely the side of the metal plate (1), which carries the multi-layer foil (2), is positively covered by these means (11).

3. Housing in accordance with Claim 1, characterised in that, the plug (3) is arranged in the immediate vicinity of the power components (5).

4. Housing in accordance with Claim 1 or 3, characterised in that, the power components (5) are bonded to the metal plate (1) with good thermal contact but in an electrical insulating manner.

5. Housing in accordance with Claim 2, characterised in that, the power components are arranged in the immediate vicinity of the plug (3).

6. Housing in accordance with Claim 2 or 5, characterised in that, the power components (5) are soldered on the multi-layer foil (2) with good thermal contact to the metal plate (1).

7. Housing in accordance with Claim 1, 3 or 4, characterised in that, the metal plate (1) is formed in the shape of a rectangle having a length (l) and a breadth (b) and the shape of the multi-layer printed circuit board (2) or the multi-layer foil (2) is chosen such that its length virtually corresponds to that of the metal plate (1) and its width is smaller than that of the metal plate (1) by an amount which is such that the thus ensuing rectangular surface on the metal plate (1) is sufficient for the reception of the power components (5).

8. Housing in accordance with Claim 2, 5 or 6, characterised in that, the metal plate (1) and the multi-layer foil (2) are formed in the shape of a rectangle having a length (l) and a breadth (b).

9. Housing in accordance with Claim 7 or 8, characterised in that, the plug (3) is placed over the full length of the metal plate (1) and that, for the mounting of the housing, the plug (3) has flange pieces (8a, 8b), which project beyond the metal plate (1) and are provided with borings (9a, 9b), on both sides, on its narrow front faces.

10. Housing in accordance with any of the preceding Claims, characterised in that, the metal plate (1) has a passage for the connecting pins (6).

11. Housing in accordance with any of the preceding Claims, characterised in that, the coupling direction (7) of the plug (3) is perpendicular to the metal plate (1).

12. Housing in accordance with any of the Claims 1 to 10, characterised in that, the coupling direction (7) of the plug (3) runs parallel to the superficial area of the metal plate (1).

13. Housing in accordance with any of the preceding Claims, characterised in that, the plug (3) is mounted mechanically rigidly on the metal plate (1) by means of fastening means (10a, 10b).

14. Housing in accordance with any of the preceding Claims, characterised in that, an economical cover, which is shaped in the form of a hood is provided as the mechanical means for covering the electronic components.

15. Housing in accordance with any of the Claims 1 to 13, characterised in that, provision is made for potting the electronic components for the purpose of covering the electronic components as well as for protection from damp and corrosion.

16. Housing in accordance with Claim 15, characterised in that, the potting is provided as a partial-section- or a complete-potting.

## Revendications

1. Boîtier destiné au montage dans un véhicule automobile pour la réception de composants électroniques disposés sur un support, lequel se trouve sur un radiateur, un connecteur à enfichage (3) établissant en outre la connexion avec les composants électroniques, caractérisé en ce que
- il contient comme support une carte multicouche (2) ou une feuille multicouche (2) portant sur un côté des composants électroniques (4) montés en surface,
- il contient comme radiateur une plaque métallique (1) dont l'étendue en surface est plus grande que celle de la carte ou de la feuille multicouche (2),
- la carte ou la feuille multicouche (2) est disposée de façon isolée sur la plaque métallique (1), de manière à suivre la surface de celle-ci,
- des composants de puissance (5) sont disposés sur l'aire de la plaque métallique (1) non recouverte par la carte ou la feuille multicouche (2), la plaque métallique (1) servant de dissipateur de chaleur pour ces composants de puissance (5),
- un connecteur à enfichage (3) est monté sur la plaque métallique (1), dans la zone de la carte ou de la feuille multicouche (2), de manière que ses broches de connexion (6) soient sorties dans la carte ou la feuille multicouche (2) et que le côté couplage (7) de ce connecteur (3) soit situé du côté de la plaque métallique (1) situé à l'opposé de celui portant la carte ou la feuille multicouche (2), et
- des moyens mécaniques (11) forment ensemble avec la plaque métallique (1) un boîtier plat, ces moyens (11) recouvrant seulement, à complémentarité de formes, le côté de la plaque métallique (1) portant la carte ou la feuille multicouche (2).

2. Boîtier destiné au montage dans un véhicule automobile pour la réception de composants électroniques disposés sur un support, lequel se trouve sur un radiateur, un connecteur à enfichage (3) établissant en outre la connexion avec les composants électroniques, caractérisé en ce que
- il contient comme support une feuille multicouche (2) portant d'un côté des composants électroniques (4) montés en surface,
- il contient comme radiateur une plaque métallique (1) dont l'étendue en surface correspond à celle de la feuille multicouche (2),
- la feuille multicouche (2) est disposée de façon isolée sur la plaque métallique (1), de manière à suivre la surface de celle-ci,
- un connecteur à enfichage (3) est monté sur la plaque métallique (1) de manière que ses broches de connexion (6) soient sorties dans la feuille multi-couche (2) et partagent la région de surface de la feuille multicouche (2) portant ces broches en une première et une seconde zone, le côté couplage (7) de ce connecteur (3) étant situé du côté de la plaque métallique (1) situé à l'opposé du côté portant la feuille multicouche (2),
- des composants de puissance sont disposés dans la première zone de la feuille multicouche (2) et
- des moyens mécaniques (11) forment ensemble avec la plaque métallique (1) un boitier plat, ces moyens (11) recouvrant seulement, à complémentarité de formes, le côté de la plaque métallique (1) portant la feuille multicouche (2).

3. Boîtier selon la revendication 1, caractérisé en ce que le connecteur (3) est placé à proximité immédiate des composants de puissance (5).

4. Boîtier selon la revendication 1 ou 3, caractérisé en ce que les composants de puissance (5) sont collés sur la plaque métallique (1) de façon isolée électriquement, mais avec un bon contact de transmission de chaleur.

5. Boîtier selon la revendication 2, caractérisé en ce que les composants de puissance sont disposés à proximité immédiate du connecteur (3).

6. Boîtier selon la revendication 2 ou 5, caractérisé en ce que les composants de puissance (5) sont soudés sur la feuille multicouche (2) de manière que soit établi un bon contact de transmission de chaleur avec la plaque métallique (1).

7. Boîtier selon la revendication 1, 3 ou 4, caractérisé en ce que la plaque métallique (1) possède une forme rectangulaire, présentant une longueur (l) et une largeur (b), et la forme de la carte ou de la feuille multicouche (2) a été choisie de manière que sa longueur corresponde presque à celle de la plaque métallique (1) et que sa largeur soit inférieure à celle de la plaque métallique (1) d'une quantité telle que l'aire de forme rectangulaire ainsi créée sur la plaque métallique (1) suffit pour recevoir les composants de puissance (5).

8. Boîtier selon la revendication 2, 5 ou 6, caractérisé en ce que la plaque métallique (1) et la feuille multicouche (2) ont une forme rectangulaire, présentant une longueur (l) et une largeur (b).

9. Boîtier selon la revendication 7 ou 8, caractérisé en ce que le connecteur (3) s'étend sur toute la longueur de la plaque métallique (1) et que le connecteur (3) comporte, en vue du montage du boîtier, des portions de bridage (8a, 8b) bilatérales sur ses petits côtés d'extrémité, portions qui sont pourvues de perçages (9a, 9b) et font saillie de la plaque métallique (1).

10. Boîtier selon une des revendications précédentes, caractérisé en ce que la plaque métallique (1) présente une traversée pour les broches de connexion (6).

11. Boîtier selon une des revendications précédentes, caractérisé en ce que la direction de couplage (7) du connecteur (3) est perpendiculaire à la plaque métallique (1).

12. Boîtier selon une des revendications 1 à 10, caractérisé en ce que la direction de couplage (7) du connecteur (3) est parallèle à l'étendue de surface de la plaque métallique (1).

13. Boîtier selon une des revendications précédentes, caractérisé en ce que le connecteur (3) est monté mécaniquement et de façon étanche sur la plaque métallique (1) par des moyens de fixation (10a, 10b).

14. Boîtier selon une des revendications précédentes, caractérisé en ce qu'un couvercle bon marché, ayant une forme de capot, est prévu en tant que moyen mécanique pour recouvrir les composants électroniques.

15. Boîtier selon une des revendications 1 à 13, caractérisé en ce qu'un encapsulage des composants électroniques est prévu pour recouvrir ces composants ainsi que comme protection contre l'humidité et la corrosion.

16. Boîtier selon la revendication 15, caractérisé en ce que l'encapsulage est partiel ou complet.
